# EUROPEAN PATENT SPECIFICATION

(11) **EP 2 243 149 B1**
(45) Date of publication and mention of the grant of the patent: **09.11.2011**
(21) Application number: 09711254.4
(22) Date of filing: 28.01.2009
(51) Int. Cl.: H01J 37/34, F16L 21/06, F16L 23/08, F16L 37/08, C23C 14/34

(54) **MULTIPLE GROOVED VACUUM COUPLING**
VAKUUMKUPPLUNG MIT MEHREREN RILLEN
COUPLAGE À VIDE À PLUSIEURS RAINURES

(30) Priority: 15.02.2008 EP 08151493
(43) Date of publication of application: 27.10.2010
(73) Proprietor: Bekaert Advanced Coatings NV., 9800 Deinze (BE)
(72) Inventor: VAN DE PUTTE, Ivan, B-8800 Roeselare (BE); GODERIS, Parsifal, B-9700 Oudenaarde (BE)
(74) Representative: Seynhaeve, Geert Filiep
(86) International application number: PCT/EP2009/050936
(87) International publication number: WO 2009/100985

(56) References cited:
- EP-A- 1 813 695
- EP-B- 1 092 109
- WO-A-2004/085902
- WO-A-2006/135528
- US-B1- 6 375 815

## Description

### Technical Field

The present invention relates to a coupling system to releasably affix a cylindrical target to a spindle.

### Background Art

Cylindrical magnetrons with rotating cylindrical targets are being used more and more over the last decade. A cylindrical target in operation must be supported, rotated, cooled and energized. Normally the sputtering installation is energized through one end block at one end of the cylindrical target (cantilever mode) or two end blocks at the two ends of the cylindrical target. The one or two end blocks are equipped with a rotatable spindle to which the target is attached. When a target is depleted, the used target must be detached form the spindle to have it replaced with a fresh one. Therefore the coupling between the spindle and the target must be releasable.

Supporting, rotating, energizing and cooling of the cylindrical targets is all done through the spindles. One side of the cylindrical target, the outer side holding target material operates under vacuum while the other side of the cylindrical target, the inner side, operates under a substantially higher pressure of a coolant - usually water - that is circulated through the target The problem of water leaks occurring at the interface between the spindle and the cylindrical target have resulted in the development of various vacuum coupling and sealing systems. In addition - certainty in the case of a cantilever mount - the moment exerted on the spindle and hence on the coupling is considerable leading to high stresses on the ends of the target, necessitating thick enough target tubes on their turn increasing the load on the spindle target coupling.

US-A-5,591,314 (Vanderstraeten, now Bekaert Advanced Coatings) discloses a coupling system to releasably affix a cylindrical target to a spindle by means of a threaded spindle collar engaging threads on the outside surface of the target. This system is known as the reference in the art and has been used on a wide scale for several years. Nevertheless this system has one drawback. The threaded spindle collar requires a screw movement to fix the target to the spindle. This screw movement makes it difficult to position a collar ring at exact right angles with respect to the spindle. The result is that the cylindrical target and the spindle risk to be not one hundred per cent aligned with each other, which is detrimental for both the life time and the sealing of the coupling.

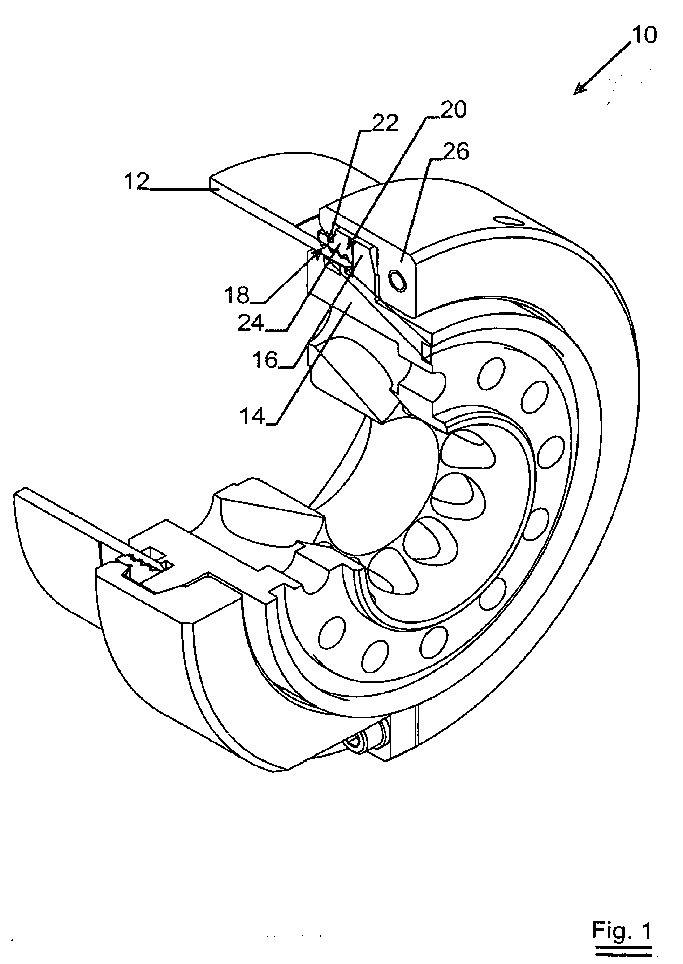

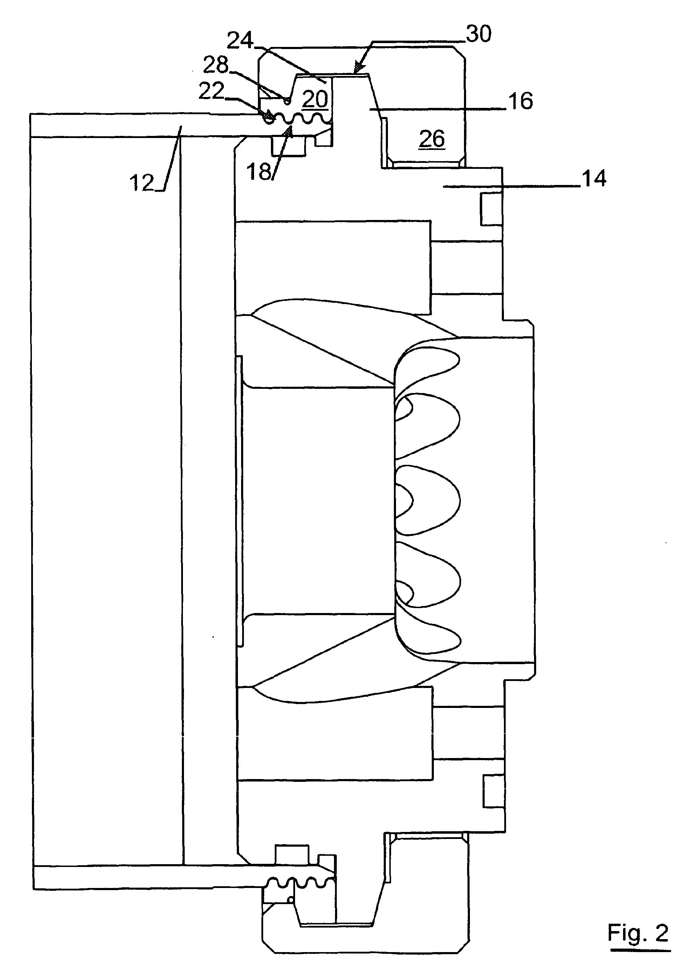

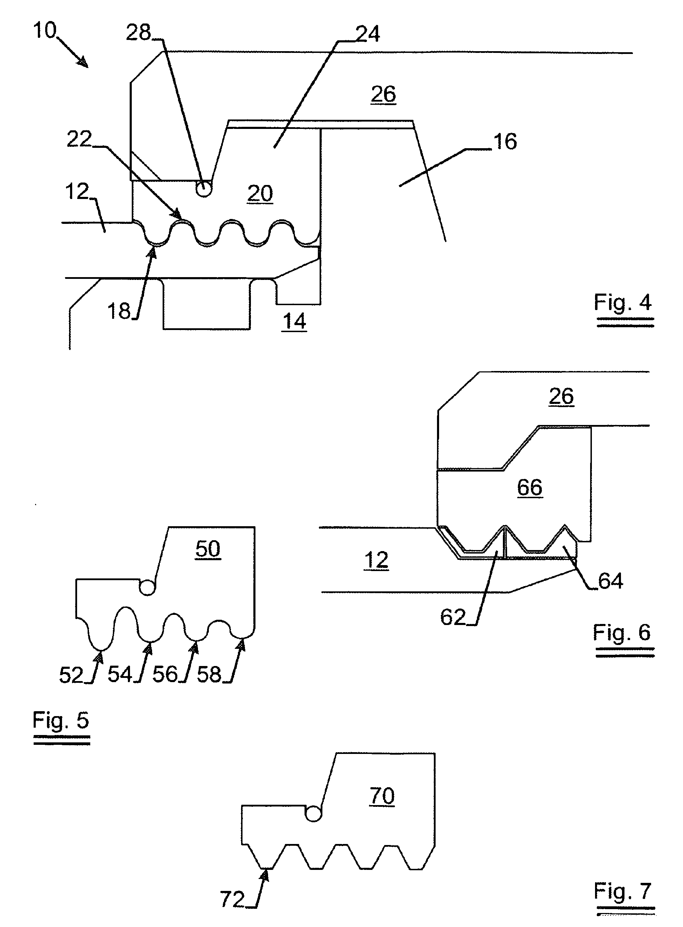

WO-A1-2004/085902 (Bekaert Advanced Coatings) discloses a universal coupling system for cylindrical targets. The embodiments disclosed in Figures 1, 2, 3, 5 and 6, on the one hand, all have the same or a similar helical thread system necessitating also a screw movement with the disadvantages as mentioned supra. Figure 4 of WO-A1-2004/085902, on the other hand, discloses a coupling with a non-helical groove. Finite element analysis and experience, however, have shown that the stresses in the neighborhood of this helical groove are unacceptably high.

WO-A2-2006/135528 (Applied Films Corporation) discloses a system using a clamp and modifications to be made to threaded targets and endblock components so that they can be clamped. The modification includes forming a circular groove near the end of the target and inserting a retaining ring in the groove to hold a flange ring that encircles the end of the target. A clamp ring fits over the flange and an adapted spindle. Targets not having a threaded portion may also be affixed in this way. However, like in the case above, the stresses in the neighborhood of a single groove, be it helical or cylindrical, will be unacceptably high.

### Disclosure of Invention

It is an object of the invention to avoid the disadvantages of the prior art.

It is a further object of the invention to provide a cylindrical magnetron sputtering system having an advanced coupling system without leakage.

It is also an object of the invention to provide a coupling system whereby the target is easily mounted and replaced.

According to a first aspect of the invention and to a first embodiment of the invention, there is provided a coupling system to releasably affix a cylindrical target to a spindle.
The coupling system comprises:
(a) a spindle having a flange portion;
(b) a cylindrical target having an end portion abutting against the flange portion of the spindle; the end portion has an outer circumferential surface;
(c) an interface ring having an inner circumferential surface adapted to engage with the outer circumferential surface of the end portion, and a flange extremity abutting against the flange portion of the spindle ; and
(d) tightening means for tightening the cylindrical target to the spindle via the interface ring.
The coupling is characterized by the end portion having two or more separate circular grooves which engage with said inner circumferential surface of the interface ring.

The separate circular grooves are not helical and do not form a screw fixation. Hence, the problem of positioning at right angles has been avoided. The two or more separate grooves allow the stresses to be spread over the various grooves, which increases life time and avoids premature fracture.

According to a preferable embodiment of the invention there are three or move separate circular grooves which engage with the inner circumferential surface of the interface ring.

The tightening means may comprise a clamping ring adapted to engage at one side with the interface ring and at another side with the spindle.

The clamping ring may be made out of two or more clamping ring segments and the interface ring may also be made of two or more interface ring segments.

The joins of the interface ring segments are covered by clamping ring segments, i.e. the joins of the interface ring segments and the joins of the clamping ring segments are not located near each other.

In an alternative embodiment the circular grooves are made by two or more separate rings positioned on the end portion of the target and forming the outer circumferential surface. These separate rings can be shifted on the target and avoid a machining on the target itself.

In a further alternative embodiment each clamping ring segments is forming a single metal piece with a corresponding interface ring segment.

In a preferable embodiment the two or more separate circular grooves are made by a machining operation in said cylindrical target.

In another alternative embodiment the circular grooves have different depths, the greater depth is preferably positioned at the side of said cylindrical target since the greater mechanical stresses are present there. However, the opposite case is also possible where the greater depths are positioned at the other side, e.g. in case of a cylindrical target with increasing thickness at the ends.

The circular grooves preferably have a rounded, rectangular or conical shape.

The coupling system may further comprise a retainer ring between the interface ring and the clamping ring. The retainer ring presses the two (or more) segments of the interface ring against one another to keep them engaged with the circular grooves at the end of the target tube for easy mounting of the target to the spindle. As an alternative the retainer ring can be an elastic sealing ring which can hold the two (or more) segments of the interface ring together on the target end during mounting.

In one embodiment the interface ring is different from the clamping ring. In another embodiment the interface ring and the clamping ring are the same piece.
As such, in an alternative embodiment there is provided a coupling system as described above, wherein each interface ring segment forms one piece with a clamping ring segment. The clamping ring segment can be shiftedly connected to the interface ring segment.

In a third embodiment there is provided a coupling system to releasably affix a cylindrical target to a spindle. The coupling system comprises:
(a) a spindle having a flange portion;
(b) a cylindrical target having at its end an outer circumferential surface and an end portion abutting against the flange portion of the spindle; and
(c) clamping means for clamping the cylindrical target to the spindle.
The clamping means having an inner circumferential surface; wherein the outer circumferential surface of the cylindrical target has two or more separate circular grooves adapted to engage with said inner circumferential surface of said clamping means.
This third embodiment avoids a separate interface ring.

The coupling system of the present invention has many advantages. Due to the repeated groove and tooth contacts between interface ring and the clamping ring (possibly in combination with a sealing ring), the seal between the target and the spindle (or endblock) is watertight so that cooling water does not flow through the outside of the target causing leaks. The seal further withstands high temperatures without failure if the target becomes too hot. The affixation is strong enough to support the target, to transmit a rotational force and to be electrically conductive. The affixation is such that attachment and detachment of the target from the spindle is fast and easy, without the need of specialized tools. Downtime for changing eroded targets is minimized in this way. More importantly, the coupling is such that mounting errors, by misalignment for example, are avoided. The coupling system furthermore is less expensive to produce than, for example, threaded couplings.

According to a second aspect of the invention, there is provided a cylindrical target adapted to work with the coupling according to the first aspect of the invention. The cylindrical target comprises an end portion. The end portion has an outer circumferential surface and the outer circumferential surface has two or more separate circular grooves.

According to a third aspect of the invention, there is provided an interface ring adapted to work with the coupling according to the first aspect of the invention. The interface ring has an inner circumferential surface. This inner circumferential surface is adapted to engage with two or more separate circular grooves in the outer circumference of the end portion of a cylindrical target.

According a fourth aspect of the invention, there is provided a backing tube that is suitable for use in a cylindrical target according the second aspect of the invention wherein said backing tube has an end portion, the outer circumferential surface of which has two or more separate circular grooves.

### Brief Description of Figures in the Drawings

Figure 1 shows a coupling system with multiple circular grooves in the cylindrical target.

Figure 2 shows a cross-sectional view of the coupling system of Figure 1.

Figures 3 shows an exploded view of the coupling system of Figure 1.

Figure 4 shows a detailed cross-sectional view of the coupling system according to the invention.

Figure 5 shows an interface ring having circular grooves with different depths.

Figure 6 shows a circular grooves on a target made by separate rings.

Figure 7 shows an interface ring having other shaped grooves.

Figure 8a shows a cross-sectional view of an alternative embodiment and Figure 8b shows an exploded view of an alternative embodiment of a coupling system.

Figure 9 shows an exploded view of yet another alternative embodiment.

### Mode(s) for Carrying Out the Invention

Figures 1, 2, 3 and 4 illustrate an embodiment of a coupling system 10 whereby a cylindrical target 12 is releasably coupled to a spindle 14.The spindle 14 has a flange portion 16. The cylindrical target 12 has two or more circular circumferential grooves 18 at the end. In one embodiment the cylindrical target 12 has four circular grooves 18. Each circular groove extends completely around the target. The grooves are positioned preferably at a regular interval parallel from each other.

The cylindrical target can be made monolithic out of the material to be sputtered and provided with the two or more circular grooves at one or both of its ends. Alternatively the cylindrical target can comprise a backing tube on which target material is deposited by electrolytic deposition, flame spraying, sputtering, clamping, welding or brazing or any such other means known in the art. The target material is deposited on the outer surface of the backing tube. The backing tube is provided with two or more circular grooves at one or both of its end portions. The advantage of the backing tube is that it can be reused: once the target material is sufficiently depleted, the backing tube mantle can again be coated with fresh material.

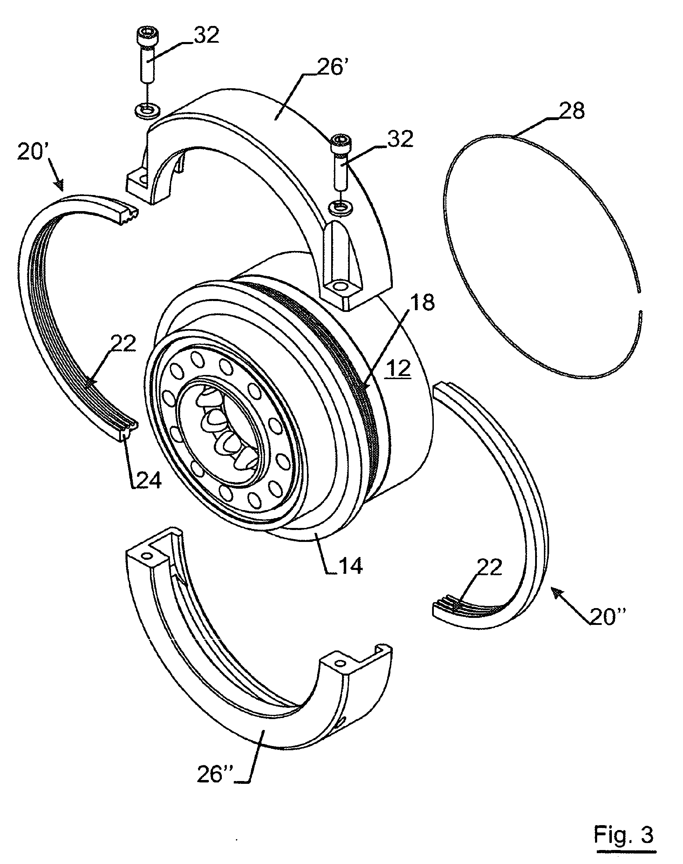

The coupling system further comprises an interface ring 20 which is composed of two or more interface ring segments 20',20". See Figure 3. The interface ring 20 has an inner diameter which is greater or equal than the outer diameter of the cylindrical target 12. The circular grooves 22 of the interface ring 20 are adapted to engage with the circular grooves 18 of the cylindrical target 12. The interface ring 20 further has a flange extremity 24. In coupled status, this flange extremity 24 of the interface ring 20 abuts against the flange portion 16 of the spindle 14.

The coupling system further comprises a clamping ring 26, which is composed of two or more clamp segments 26',26". Each clamp segment has an inwardly oriented clamp recess 30. In coupled status this clamp recess 30 encloses the flange portion 16 of the spindle 14 and the flange extremity 24 of the interface ring 20. Preferably the surfaces of the flange portion 16 and the flange extremity 24 are slightly conical. The clamp recess 30 also has a matching conical surface.

The coupling system further comprises a 'C' shaped, retainer ring 28 fitting in a recess of the interface ring 20, for holding both interface ring segments on the end of the target during the mounting of the target. In an alternative embodiment the retainer ring 28 may be an elastic sealing O-ring which provides an additional sealing function when compressed between the interface ring 20 and the clamping ring 26. (Fig 3).

Figure 3 shows a demounted view of the coupling system 10. Firstly the interface ring segments 20',20" are engaged with the circular grooves 18 at the end of the target 12 and held in position with the retainer ring 28. Then the cylindrical target 12 is slid onto the spindle 14, so that the end of the cylindrical target 12 abuts the lower part of the flange portion 16 of the spindle 14. Finally the two clamping ring segments 26' and 26" are mounted onto the interface ring segments 20' and 20" and the flange portion 16 of the spindle 14. The two clamping ring segments 26' and 26" are joined together at places which do not correspond to the places where the two interface ring segments 20' and 20" join one another. Preferably, the joining position of the two clamping ring segments 26' and 26" is shifted 90 degrees from the joining of the two interface ring segments 20' and 20". The clamp segments of the clamping ring 26 are held together by fastening means, such as a bolt or a screw 32 (Fig 3).

Figure 5 shows an embodiment of a coupling system comprising an interface ring 50 having grooves (52, 54, 56, 58) with different depths. The greater depth of groove 52 is at the side of the cylindrical target 12, and this for reasons of a greater tension at that side. In another embodiment only groove 52 is deeper, while the other grooves (54, 56, 58) have an equal depth.

Figure 6 shows an alternative embodiment where the grooves on the end portion of the cylindrical target 12 are realized by means of two separate rings 62, 64. An interface ring 66 has an inner circumferential surface closely engaging with these separate rings 62, 64. This embodiment has the advantage that the circular grooves need not to be made by machining the end portion of the cylindrical target 12. Hence, there is no weakening of the end portion of the cylindrical target 12.

Figure 7 shows an alternative embodiment of an interface ring 70 with circular grooves having a different shape (conical) in cross-section. Another example of a groove shape is a rectangular groove.

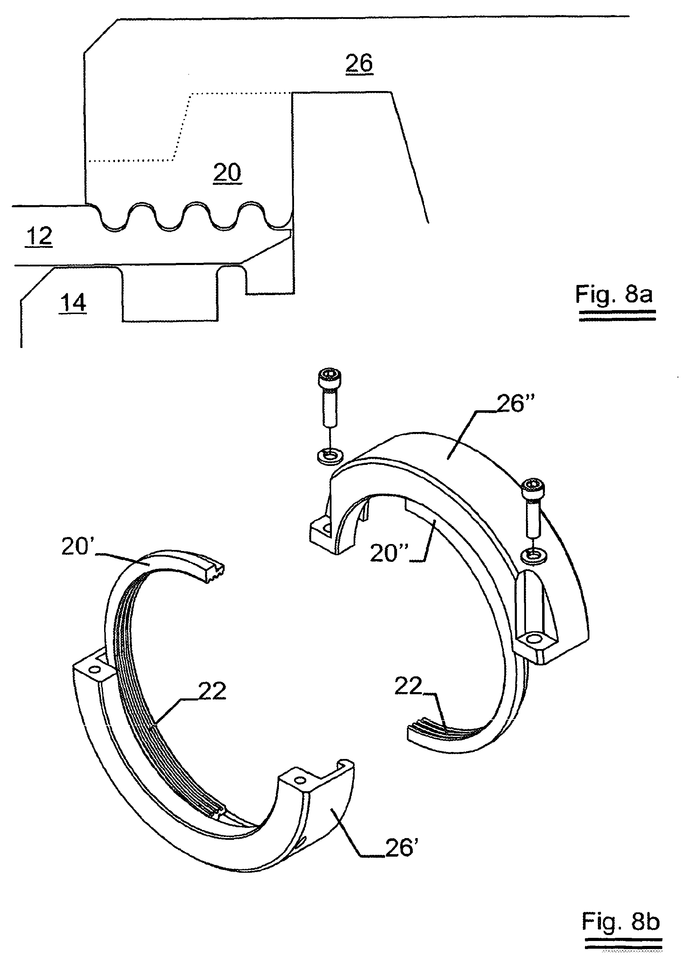

Figure 8a and Figure 8b show alternative embodiments where the interface ring and the clamping ring are one piece. This facilitates mounting and demounting even more. In one embodiment the interface ring and the clamping ring are fixed together as to form one piece. This is illustrated by the cross-section in Figure 8a.
In still another embodiment of Figure 8b an interface ring segment 20', 20" is fixed to a clamping ring segment 26', 26" so that it is shifted over some degrees and protrudes somewhat out of the clamping ring. In this way the joins of the interface ring segments are shifted towards the joins of the clamping ring segments, as such providing extra sealing.

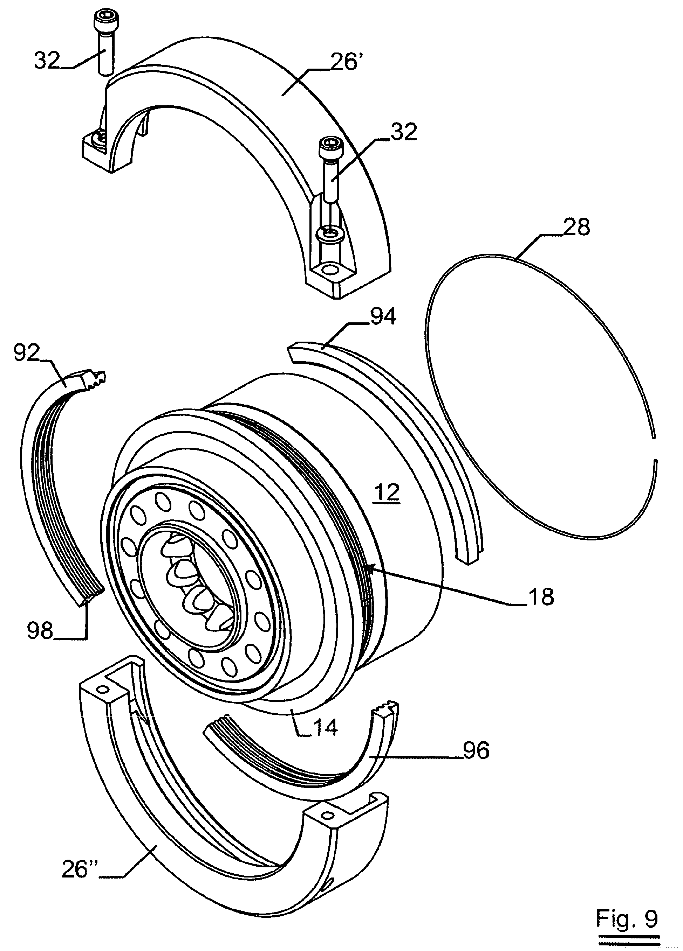

Figure 9 shows an exploded view of yet another embodiment of the coupling according to the invention. The difference with the embodiment of Figures 1, 2, 3 and 4 mainly lies in the interface ring. In this new embodiment the interface ring has three segments 92, 94 and 96 instead of only two segments. All these segments cover about 120° (instead of 180° in Figures 1, 2, 3 and 4).

**List of Reference Numbers**
- 10: coupling system
- 12: cylindrical target
- 14: spindle

- 16: flange portion of spindle
- 18: circular grooves of target
- 20: interface ring
- 20': first half of interface ring
- 20": second half of interface ring
- 22: circular grooves of interface ring
- 24: flange extremity of interface ring
- 26: clamping ring
- 26': first half of clamping ring
- 26": second half of claiming ring
- 28: retainer ring
- 30: clamp recess
- 32: bolt
- 50: interface ring with grooves of varying depth
- 52,: 54, 56, 58 grooves of varying depth
- 62, 64: rings forming grooves on target
- 66: interface ring engaging with rings on target
- 70: interface ring with conical grooves
- 72: conical groove
- 92, 94, 96 120°: degree segments of interface ring
- 98: flange extremity of interface ring

## Claims

1. A coupling system (10) to releasably affix a cylindrical target (12) to a spindle (14), said coupling system comprising:
a) a spindle (14) having a flange portion (16);
b) a cylindrical target (12) having an end portion abutting against said flange portion (16) of said spindle (14), said end portion having an outer circumferential surface;
c) an interface ring (20) having an inner circumferential surface adapted to engage with said outer circumferential surface of said end portion, and a flange extremity (24) abutting against said flange portion (16) of said spindle (14);
d) tightening means (26) for tightening said cylindrical target (12) to said spindle (14) via said interface ring (20);
**characterized in that**
said end portion has two or more separate circular grooves (18) which engage with said inner circumferential surface (22) of said interface ring (20).

2. A coupling system (10) according to claim 1,
wherein said end portion has three or more separate circular grooves (18).

3. A coupling system (10) according to claim 1 or 2, wherein said tightening means (26) comprise a clamping ring (26) adapted to engage at one side with said interface ring (20) and at another side with said spindle (14).

4. A coupling system (10) according to any one of the preceding claims wherein said two or more separate circular grooves (10) are made by machining in said cylindrical target (12).

5. A coupling system (10) according to any one of the preceding claims wherein said clamping ring (26) is made out of two or more clamping ring segments (26', 26") and said interface ring (20) of two or more interface ring segments (20', 20").

6. A coupling system (10) according to any one of the preceding claims wherein the joins of the interface ring segments are covered by clamping ring segments.

7. A coupling system (10) according to any one of the preceding claims, wherein said clamping ring segments (26', 26") form each one single piece with said interface ring segments (20', 20").

8. A coupling system (10) according to any one of the preceding claims, wherein said circular grooves (18) have different depths, the greater depth being at the side of said cylindrical target.

9. A coupling system (10) according to any one of the preceding claims, wherein said circular grooves (18) are made by two or more separate rings (62, 64) positioned on said end portion of said target (12) and forming said outer circumferential surface.

10. A coupling system (10) according to any one of the preceding claims, further comprising a sealing ring (28) between said interface ring (20) and said clamping ring (26).

11. A coupling system (10) according to any one of the preceding claims, wherein said circular grooves (18) have a rounded, rectangular or conical shape.

12. A coupling system (10) according to any one of the preceding claims, wherein each interface ring segment (20'or 20") forms one piece with a clamping ring segment (26' or 26"), said clamping ring segment shiftedly connected to said interface ring segment.

13. A coupling system (10) to releasably affix a cylindrical target (12) to a spindle (14), said coupling system comprising:
a) a spindle (14) having a flange portion (16);
b) a cylindrical target (12) having at its end an outer circumferential surface and an end portion abutting against said flange portion (16) of said spindle (14);
c) clamping means (26) for clamping said cylindrical target (12) to said spindle (14), said clamping means having an inner circumferential surface; **characterized in that**
said outer circumferential surface of said cylindrical target (12) has two or more separate circular grooves (18) adapted to engage with said inner circumferential surface of said clamping means (26).

14. A cylindrical target (12) adapted to work with the coupling of claims 1 to 13, said cylindrical target comprising an end portion, said end portion having an outer circumferential surface, said outer circumferential surface having two or more separate circular grooves (18).

15. A backing tube suitable for use in a cylindrical target (12), said backing tube being adapted to work with the coupling of claims 1 to 13, said backing tube therefore comprising an end portion, said end portion having an outer circumferential surface, said outer circumferential surface having two or more separate circular grooves (18).

16. An interface ring (20) adapted to work with the coupling of claims 1 to 13, said interface ring having an inner circumferential surface, said inner circumferential surface being adapted to engage with two or more separate circular grooves (18) in the outer circumference of the end portion of a cylindrical target (12).

## Patentansprüche

1. Kupplungssystem (10) zum lösbaren Befestigen eines zylinderförmigen Targets (12) an einer Spindel (14), wobei das Kupplungssystem Folgendes umfasst:
a) eine Spindel (14), die einen Flanschteil (16) umfasst;
b) ein zylinderförmiges Target (12), das einen Endteil umfasst, der an den Flanschteil (16) der Spindel (14) anstößt, wobei der Endteil eine äußere umlaufende Fläche aufweist;
c) einen Zwischenring (20), der eine innere umlaufende Fläche aufweist, die angepasst ist, um in die äußere umlaufende Fläche des Endteils einzugreifen, und ein Flanschende (24), das an den Flanschteil (16) der Spindel (14) anstößt;
d) Anziehmittel (26) zum Festmachen des zylinderförmigen Targets (12) an der Spindel (14) über den Zwischenring (20);
**dadurch gekennzeichnet, dass**
der Endteil zwei oder mehr separate kreisförmige Nuten (18) aufweist, die in die innere umlaufende Fläche (22) des Zwischenrings (20) eingreifen.

2. Kupplungssystem (10) nach Anspruch 1, wobei der Endteil drei oder mehr separate kreisförmige Nuten (18) aufweist.

3. Kupplungssystem (10) nach Anspruch 1 oder 2, wobei die Anziehmittel (26) einen Spannring (26) umfassen, der angepasst ist, um auf einer Seite in den Zwischenring (20) und auf einer anderen Seite in die Spindel (14) einzugreifen.

4. Kupplungssystem (10) nach einem der vorhergehenden Ansprüche, wobei die zwei oder mehr separaten kreisförmigen Nuten (18) durch spanende Bearbeitung im zylinderförmigen Target (12) ausgeführt werden.

5. Kupplungssystem (10) nach einem der vorhergehenden Ansprüche, wobei der Spannring (26) aus zwei oder mehr Spannringsegmenten (26', 26") und der Zwischenring (20) aus zwei oder mehr Zwischenringsegmenten (20', 20") gemacht ist.

6. Kupplungssystem (10) nach einem der vorhergehenden Ansprüche, wobei die Verbindungsstellen der Zwischenringsegmente von Spannringsegmenten abgedeckt werden.

7. Kupplungssystem (10) nach einem der vorhergehenden Ansprüche, wobei die Spannringsegmente (26', 26") jeweils ein Einzelstück mit den Zwischenringsegmenten (20', 20") bilden.

8. Kupplungssystem (10) nach einem der vorhergehenden Ansprüche, wobei die kreisförmigen Nuten (18) unterschiedliche Tiefen aufweisen, wobei sich die größeren Tiefen auf Seite des zylinderförmigen Targets befinden.

9. Kupplungssystem (10) nach einem der vorhergehenden Ansprüche, wobei die kreisförmigen Nuten (18) von zwei oder mehr separaten Ringen (62, 64) gebildet werden, die am Endteil des Targets (12) angeordnet sind und die äußere umlaufende Fläche bilden.

10. Kupplungssystem (10) nach einem der vorhergehenden Ansprüche, ferner umfassend einen Dichtungsring (28) zwischen dem Zwischenring (20) und dem Spannring (26).

11. Kupplungssystem (10) nach einem der vorhergehenden Ansprüche, wobei die kreisförmigen Nuten (18) eine gerundete, rechteckige oder konische Form haben.

12. Kupplungssystem (10) nach einem der vorhergehenden Ansprüche, wobei jedes Zwischenringsegment (20' oder 20") einen Teil mit einem Spannringsegment (26' oder 26") bildet, wobei das Spannringsegment mit dem Zwischenringsegment versetzt verbunden ist.

13. Kupplungssystem (10) zum lösbaren Befestigen eines zylinderförmigen Targets (12) an einer Spindel (14), wobei das Kupplungssystem Folgendes umfasst:
a) eine Spindel (14), die einen Flanschteil (16) umfasst;
b) ein zylinderförmiges Target (12), das an seinem Ende eine äußere umlaufende Fläche und einen Endteil umfasst, der an den Flanschteil (16) der Spindel (14) anstößt;
c) Spannmittel (26) zum Festpannen des zylinderförmigen Targets (12) an der Spindel (14), wobei die Spannmittel eine innere umlaufende Fläche aufweisen;
**dadurch gekennzeichnet, dass**
die äußere umlaufende Fläche des zylinderförmigen Targets (12) zwei oder mehr separate kreisförmige Nuten (18) aufweist, die angepasst sind, um in die innere umlaufende Fläche der Spannmittel (26) einzugreifen.

14. Zylinderförmiges Target (12), das angepasst ist, um mit der Kupplung nach Anspruch 1 bis 13 zu funktionieren, wobei das zylinderförmige Target einen Endteil umfasst, wobei der Endteil eine äußere umlaufende Fläche aufweist, wobei die äußere umlaufende Fläche zwei oder mehr separate kreisförmige Nuten (18) aufweist.

15. Sicherungsrohr, das für die Verwendung in einem zylinderförmigen Target (12) geeignet ist, wobei das Sicherungsrohr angepasst ist, um mit der Kupplung nach Anspruch 1 bis 13 zu funktionieren, weshalb das Sicherungsrohr einen Endteil umfasst, wobei der Endteil eine äußere umlaufende Fläche aufweist, wobei die äußere umlaufende Fläche zwei oder mehr separate kreisförmige Nuten (18) aufweist.

16. Zwischenring (20), der angepasst ist, um mit der Kupplung nach Anspruch 1 bis 13 zu funktionieren, wobei der Zwischenring eine innere umlaufende Fläche aufweist, wobei die innere umlaufende Fläche angepasst ist, um in zwei oder mehr separate kreisförmige Nuten (18) am äußeren Umfang des Endteils eines zylinderförmigen Targets (12) einzugreifen.

## Revendications

1. Système d'accouplement (10) pour fixer de façon libérable une cible cylindrique (12) à une broche (14), ledit système d'accouplement comprenant :
a) une broche (14) possédant une partie de bride (16) ;
b) une cible cylindrique (12) possédant une partie d'extrémité prenant appui contre ladite partie de bride (16) de ladite broche (14), ladite partie d'extrémité possédant une surface circonférentielle extérieure ;
c) une bague d'interface (20) possédant une surface circonférentielle intérieure adaptée pour entrer en prise avec ladite surface circonférentielle extérieure de ladite partie d'extrémité, et une extrémité de bride (24) prenant appui contre ladite partie de bride (16) de ladite broche (14) ;
d) un moyen de resserrage (26) pour resserrer ladite cible cylindrique (12) sur ladite broche (14) par l'intermédiaire de ladite bague d'interface (20) ;
**caractérisé en ce que**
ladite partie d'extrémité possède deux, ou plus, rainures circulaires séparées (18) qui entrent en prise avec ladite surface circonférentielle intérieure (22) de ladite bague d'interface (20).

2. Système d'accouplement (10) selon la revendication 1, dans lequel ladite partie d'extrémité possède trois, ou plus, rainures circulaires séparées (18).

3. Système d'accouplement (10) selon la revendication 1 ou 2, dans lequel ledit moyen de resserrage (26) comprend une bague de serrage (26) adaptée pour entrer en prise sur un côté avec ladite bague d'interface (20) et sur un autre côté avec ladite broche (14).

4. Système d'accouplement (10) selon une quelconque des revendications précédentes, dans lequel lesdites deux, ou plus, rainures circulaires séparées (18) sont réalisées par usinage dans ladite cible cylindrique (12).

5. Système d'accouplement (10) selon une quelconque des revendications précédentes, dans lequel ladite bague de serrage (26) est composée de deux, ou plus, segments de bague de serrage (26', 26") et ladite bague d'interface (20) de deux, ou plus, segments de bague d'interface (20', 20").

6. Système d'accouplement (10) selon une quelconque des revendications précédentes, dans lequel les joints des segments de bague d'interface sont recouverts par des segments de bague de serrage.

7. Système d'accouplement (10) selon une quelconque des revendications précédentes, dans lequel lesdits segments de bague de serrage (26', 26") forment chacun une pièce unique avec lesdits segments de bague d'interface (20', 20").

8. Système d'accouplement (10) selon une quelconque des revendications précédentes, dans lequel lesdites rainures circulaires (18) possèdent des profondeurs différentes, la profondeur plus importante étant sur le côté de ladite cible cylindrique.

9. Système d'accouplement (10) selon une quelconque des revendications précédentes, dans lequel lesdites rainures circulaires (18) sont composées par deux, ou plus, bagues séparées (62, 64) positionnées sur ladite partie d'extrémité de ladite cible (12) et formant ladite surface circonférentielle extérieure.

10. Système d'accouplement (10) selon une quelconque des revendications précédentes, comprenant en outre une bague d'étanchéité (28) entre ladite bague d'interface (20) et ladite bague de serrage (26).

11. Système d'accouplement (10) selon une quelconque des revendications précédentes, dans lequel lesdites rainures circulaires (18) possèdent une forme arrondie, rectangulaire ou conique.

12. Système d'accouplement (10) selon une quelconque des revendications précédentes, dans lequel chaque segment de bague d'interface (20' ou 20") forme une pièce avec un segment de bague de serrage (26' ou 26"), ledit segment de bague de serrage étant relié de façon déplacée audit segment de bague d'interface.

13. Système d'accouplement (10) pour fixer de façon libérable une cible cylindrique (12) à une broche (14), ledit système d'accouplement comprenant :
a) une broche (14) possédant une partie de bride (16) ;
b) une cible cylindrique (12) possédant, à son extrémité, une surface circonférentielle extérieure et une partie d'extrémité prenant appui contre ladite partie de bride (16) de ladite broche (14) ;
c) un moyen de serrage (26) pour serrer ladite cible cylindrique (12) sur ladite broche (14), ledit moyen de serrage possédant une surface circonférentielle intérieure ;
**caractérisé en ce que**
ladite surface circonférentielle extérieure de ladite cible cylindrique (12) possède deux, ou plus, rainures circulaires séparées (18) adaptées pour entrer en prise avec ladite surface circonférentielle intérieure dudit moyen de serrage (26).

14. Cible cylindrique (12) adaptée pour fonctionner avec l'accouplement selon les revendications 1 à 13, ladite cible cylindrique comprenant une partie d'extrémité, ladite partie d'extrémité possédant une surface circonférentielle extérieure, ladite surface circonférentielle extérieure possédant deux, ou plus, rainures circulaires séparées (18).

15. Tube de support approprié pour être utilisé dans une cible cylindrique (12), ledit tube de support étant adapté pour fonctionner avec l'accouplement selon les revendications 1 à 13, ledit tube de support comprenant donc une partie d'extrémité, ladite partie d'extrémité possédant une surface circonférentielle extérieure, ladite surface circonférentielle extérieure possédant deux, ou plus, rainures circulaires séparées (18).

16. Bague d'interface (20) adaptée pour fonctionner avec l'accouplement selon les revendications 1 à 13, ladite bague d'interface possédant une surface circonférentielle intérieure, ladite surface circonférentielle intérieure étant adaptée pour entrer en prise avec deux, ou plus, rainures circulaires séparées (18) dans la circonférence extérieure de la partie d'extrémité d'une cible cylindrique (12).
